(19) Europäisches Patentamt
European Patent Office
Office européen des brevets

(11) **EP 3 571 834 B1**

(12) **FASCICULE DE BREVET EUROPEEN**

(45) Date de publication et mention
de la délivrance du brevet:
**30.06.2021 Bulletin 2021/26**

(51) Int Cl.:
**H04N 5/235** *(2006.01)* **H04N 5/353** *(2011.01)*
**H04N 5/355** *(2011.01)* **H04N 5/372** *(2011.01)*
**H04N 5/3745** *(2011.01)*

(21) Numéro de dépôt: **17822691.6**

(22) Date de dépôt: **22.12.2017**

(86) Numéro de dépôt international:
**PCT/EP2017/084393**

(87) Numéro de publication internationale:
**WO 2018/134029 (26.07.2018 Gazette 2018/30)**

(54) **GÉNÉRATION ADAPTATIVE D'UNE IMAGE À GRANDE GAMME DYNAMIQUE D'UNE SCÈNE, À PARTIR D'UNE PLURALITÉ D'IMAGES OBTENUES PAR LECTURE NON DESTRUCTIVE D'UN CAPTEUR D'IMAGE**

ADAPTIVE ERZEUGUNG EINES BILDES MIT HOHEM DYNAMIKBEREICH EINER SZENE BASIEREN AUF EINER VIELZAHL VON BILDERN, DIE DURCH ZERSTÖRUNGSFREIES LESEN EINES BILDSENSORS GEWONNEN WERDEN

ADAPTIVE GENERATION OF A HIGH DYNAMIC RANGE IMAGE OF A SCENE, ON THE BASIS OF A PLURALITY OF IMAGES OBTAINED BY NON-DESTRUCTIVE READING OF AN IMAGE SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.01.2017 FR 1750359**

(43) Date de publication de la demande:
**27.11.2019 Bulletin 2019/48**

(73) Titulaires:
• **Centre National de la Recherche Scientifique**
**75016 Paris 16 (FR)**
• **Sorbonne Université**
**75006 Paris (FR)**
• **Université Paris Diderot - Paris 7 Diderot Valorisation**
**75013 Paris (FR)**
• **Ecole Normale Supérieure de Paris**
**75005 Paris (FR)**
• **Université de Bourgogne**
**21000 Dijon Cedex (FR)**

(72) Inventeurs:
• **DARSON, David**
**77000 Vaux le Pénil (FR)**
• **DUBOIS, Julien**
**21800 Quétigny (FR)**
• **HEYRMAN, Barthélémy**
**21800 Quétigny (FR)**
• **GINHAC, Dominique**
**21110 Thorey en Plaine (FR)**
• **BOUDERBANE, Mustapha**
**91230 Montgeron (FR)**

(74) Mandataire: **Lavoix**
**2, place d'Estienne d'Orves**
**75441 Paris Cedex 09 (FR)**

(56) Documents cités:
**US-A1- 2007 268 396     US-A1- 2015 130 967
US-B1- 6 219 097**

• **SAMUEL W HASINOFF ET AL: "Noise-optimal capture for high dynamic range photography", 2010 IEEE CONFERENCE ON COMPUTER VISION AND PATTERN RECOGNITION (CVPR), 13-18 JUNE 2010, SAN FRANCISCO, CA, USA, IEEE, PISCATAWAY, NJ, USA, 13 juin 2010 (2010-06-13), pages 553-560, XP031725992, ISBN: 978-1-4244-6984-0**

**Description**

## 1. Domaine de l'invention

Le domaine de l'invention est celui de l'acquisition d'images au moyen de dispositifs de captures tels que des appareils photos numériques (APN), des caméras, des microscopes, des téléphones intelligents (en anglais « smartphones ») équipés d'APN, etc. Plus précisément, l'invention concerne une méthode d'acquisition d'images à grande gamme dynamique, ou HDR (pour l'anglais « High Dynamic Range »).

Elle trouve des applications notamment, mais non exclusivement, dans le domaine du cinéma, de la vidéo-surveillance, du transport aérien ou routier, du contrôle non-destructif, dans le domaine médical, ou encore dans celui des sciences fondamentales comme la physique, l'astronomie, etc.

## 2. Art antérieur et ses inconvénients

Les performances des dispositifs de capture d'image existants sont souvent limitées par l'étroitesse de leur gamme dynamique. Ainsi, lorsqu'une scène à capturer, sous forme d'image fixe ou de vidéo, présente de forts contrastes, l'image restituée par le dispositif de capture peut présenter des zones surexposées, dans lesquelles les pixels de l'image sont saturés, correspondant aux zones très lumineuses de la scène, et des zones sombres, aux détails peu ou pas visibles, correspondant aux zones peu éclairées de la scène.

Pour résoudre ce problème, et générer, à partir de dispositifs de capture existants, des images à grande gamme dynamique, dites images HDR, il a été envisagé de combiner plusieurs images classiques, dites LDR (pour l'anglais « Low Dynamic Range », faible gamme dynamique), associées à des temps de pose différents. Ainsi, la scène à imager est photographiée à plusieurs reprises, par le même dispositif de capture, avec des temps de pose différents : les temps de pose courts permettent de ne pas saturer les zones de l'image à forte luminosité, et les temps de pose longs permettent de détecter un signal utile dans les zones à faible luminosité. Les différentes images LDR obtenues sont ensuite traitées pour extraire de chacune les parties de l'image ayant le meilleur rendu, et ces différentes parties sont combinées pour construire une image HDR de la scène.

Ce procédé de génération d'image HDR s'avère coûteux en temps et en nombre de poses à réaliser. De ce fait, il n'est notamment pas adapté à la génération d'une séquence vidéo HDR, du fait de son caractère non temps réel.

En outre, lorsque la scène à imager comprend des éléments en mouvement, ils peuvent occuper des positions différentes dans les différentes images LDR capturées, ce qui peut entraîner l'apparition d'artefacts lors de la génération de l'image HDR. Ces effets de fantômes peuvent être corrigés avant la reconstruction de l'image HDR, mais au prix d'une électronique de traitement complexe et coûteuse. Un algorithme de suppression de tels artefacts est présenté par exemple par Mustapha Bouderbane et al. dans l'article « Suppression de l'artéfact de ghost pour la génération de vidéo HDR temps-réel », Compas'2016 : Parallélisme/Architecture/Système, Lorient, France, du 5 au 8 juillet 2016.

L'évolution des détecteurs embarqués dans ces dispositifs de capture d'image permet désormais à ces derniers de fonctionner en mode de lecture non destructive, ou NDRO pour l'anglais « Non Destructive Read Out ». Dans ce mode de fonctionnement, les charges électriques accumulées par les éléments de conversion photoélectrique du détecteur peuvent être lues, sans remise à zéro : il est ainsi possible, pendant la durée de l'exposition du capteur, de procéder à plusieurs lectures des signaux de pixels, tout en permettant aux charges électriques de continuer à s'accumuler, sous l'effet de l'exposition du capteur à la lumière.

L'exploitation de ce mode de lecture non destructive, qui permet plusieurs lectures des signaux associés aux pixels du capteur pendant un seul temps de pose, offre une solution intéressante, tant au problème du coût temporel des méthodes de génération d'images HDR antérieures, qu'à celui de l'apparition d'artefacts. Il est en effet possible de générer une image à grande gamme dynamique d'une scène à partir de plusieurs images obtenues par lecture non destructive du capteur au cours d'un même temps de pose.

Ainsi, le document de brevet US 7,868,938 propose un nouveau type de dispositif de capture d'image, dans lequel un premier lecteur opère une lecture des charges accumulées par les éléments de conversion photoélectrique du capteur en mode de lecture destructive, avec remise à zéro des signaux des pixels après chaque lecture, à l'issue d'un temps d'exposition standard, et un second lecteur fonctionne en mode de lecture non destructive, pour obtenir plusieurs images NDRO associées à différents temps d'exposition courts, i.e. plus courts que le temps d'exposition standard. Les différentes images NDRO associées à des temps d'exposition courts sont utilisées pour prédire si certains pixels de l'image obtenue par le premier lecteur seront saturés, du fait d'une surexposition des parties correspondantes de la scène à imager pendant le temps d'exposition standard. Dans l'affirmative, une image HDR est générée dans laquelle les pixels saturés de l'image obtenue par le premier lecteur dans le temps d'exposition standard sont remplacés par les pixels non saturés correspondants extraits d'une image NDRO associée à un temps d'exposition plus court.

Si elle est intéressante en ce qu'elle permet, par rapport aux techniques antérieures, de réduire le temps nécessaire à la génération d'une image à grande gamme dynamique, cette méthode présente cependant encore plusieurs inconvénients, parmi lesquels un besoin en puissance de calcul élevé, lié aux multiples lectures non destructives successives du capteur requises.

En outre, cette technique, qui apporte une solution intéressante à la problématique de la saturation de certaines zones de l'image, ne permet pas de résoudre le problème des zones faiblement exposées. En effet, selon cette technique, les pixels saturés de l'image via une pose classique sont « dé-saturés », car remplacés par les mêmes pixels issus de lectures NDRO avec des temps de pose équivalents plus courts ; en revanche, cette technique ne permet pas de s'adapter aux faibles signaux, qui sont fixés par l'accumulation liée à la pose classique.

Il existe donc un besoin d'une technique de génération d'une image à grande gamme dynamique ne présentant pas ces différents inconvénients de l'art antérieur. Notamment, il existe un besoin d'une telle technique qui soit moins coûteuse, tant en temps qu'en puissance de calcul. Il existe également un besoin d'une telle technique de génération d'image HDR qui soit adaptative, et puisse ajuster automatiquement le nombre de lectures NDRO requises au niveau de luminosité de la scène à rendre en image HDR, en fonction de la qualité de l'image finale visée, et de la dynamique finale souhaitée tant par les forts signaux que les faibles signaux.

## 3. Exposé de l'invention

L'invention répond à ce besoin en proposant un procédé de génération d'une image à grande gamme dynamique d'une scène, à partir d'une pluralité d'images de la scène obtenues par lecture non destructive d'un capteur d'image, appelées images NDRO. Le capteur comprend une pluralité de pixels agencés sous forme matricielle, et associés chacun à un élément de conversion photoélectrique permettant de convertir une lumière reçue en charges électriques et d'accumuler les charges électriques pendant un temps d'exposition à la lumière.

Selon l'invention, un tel procédé comprend :

- une première lecture non destructive dudit capteur d'image, délivrant une première image NDRO courante d'indice n=0, et une mémorisation de ladite première image, au sein d'une zone mémoire, en association avec un temps d'exposition associé à ladite première image ;
- pour chaque pixel de ladite première image, une comparaison d'une valeur de signal correspondant auxdites charges électriques accumulées par ledit pixel à un seuil de sélection de signal, et une sélection dudit pixel si ladite valeur de signal associée audit pixel est supérieure audit seuil de sélection de signal ;
- au moins une itération des étapes successives suivantes, pour n entier, n variant de 1 à N :

    - une lecture non destructive dudit capteur d'image, délivrant une image NDRO courante d'indice n ;
    - une actualisation de ladite zone mémoire par mémorisation, pour chaque pixel de ladite image NDRO courante d'indice n non précédemment sélectionné dans une image NDRO précédant ladite image NDRO courante, d'une valeur de signal associée audit pixel, en association avec un temps d'exposition associé à ladite image NDRO courante d'indice n ;
    - pour chaque pixel de ladite image NDRO courante d'indice n, une comparaison d'une valeur de signal correspondant auxdites charges électriques accumulées par ledit pixel audit seuil de sélection de signal, et une sélection dudit pixel si ladite valeur de signal associée audit pixel est supérieure audit seuil de sélection de signal ;

- une génération de ladite image à grande gamme dynamique à partir desdites valeurs de signal associées auxdits pixels sélectionnés et desdits temps d'exposition mémorisés en association.

Ainsi, l'invention repose sur une approche tout à fait nouvelle et inventive de la génération d'images HDR à partir d'une pluralité d'images dites NDRO, i.e. obtenues par lecture non destructive des pixels du capteur. Un tel procédé est adaptatif, en ce qu'il permet d'optimiser le nombre de lectures non destructives à opérer, ainsi que leurs temps d'exposition associés, en regard des caractéristiques de la scène à imager.

En effet, le procédé de l'invention, selon un mode de réalisation, propose de procéder à plusieurs itérations d'une lecture du capteur en mode de lecture non destructive, et d'optimiser dynamiquement le nombre de lectures nécessaires à la reconstruction HDR, en déterminant, en fonction d'un critère de qualité visé de l'image HDR finale, quelle est la première image NDRO dans laquelle un ou plusieurs pixels répondent aux critères de qualité déterminés pour l'image HDR. Ces pixels sont sélectionnés et mémorisés dans une zone mémoire unique, constituant une image du capteur. A chaque nouvelle image NDRO successive, on sélectionne de nouveaux pixels répondant aux critères de qualité déterminés pour l'image HDR, s'ils existent, et on actualise en conséquence la zone mémoire. Les valeurs des pixels précédemment sélectionnés et mémorisés dans les images NDRO précédentes restent quant à elles figées, et ne sont pas actualisées. On construit ainsi progressivement une image du capteur mémorisant en association les valeurs des pixels répondant aux critères de qualité souhaités, en association avec les temps d'exposition des images NDRO dont ils sont extraits.

Plus précisément, on définit un seuil de sélection $S_{sel}$ tel que $S_0 \leq S_{sel} \leq S_{sat}$, où $S_0$ est le signal correspondant au signal électronique exploitable le plus faible issu du détecteur (typiquement, le signal dont le niveau correspond au bruit de lecture du détecteur ou plus généralement du système imageur), et où $S_{sat}$ est le signal de saturation du capteur (imposé par le premier élément saturé dans le détecteur : pixel, chaîne de conversion de charge et/ou d'amplification...). Ce seuil de sélection de signal est défini avant le début de l'acquisition des images NDRO, et peut être modifié pour chaque nouvelle séquence d'images NDRO en vue d'une reconstruction HDR. Ainsi, il peut être modifié pour s'adapter au mieux aux conditions d'illumination de la scène (et donc à la dynamique à imager), ou pour optimiser le temps de pose ou le RSB final des signaux les plus faibles par exemple.

Dès que la valeur de signal d'un pixel atteint ce seuil de sélection, ce pixel est sélectionné pour la reconstruction de l'image HDR, et mémorisé, en association avec le temps d'exposition de l'image NDRO dont il est extrait. Le premier pixel sélectionné définit, en conséquence, la première image NDRO à utiliser pour la reconstruction de l'image HDR.

On ajuste ainsi à la volée le nombre de lectures non destructives à effectuer pour atteindre le niveau de qualité visé de l'image HDR, en fonction notamment des niveaux de luminosité de la scène à imager.

Cet ajustement dynamique du nombre de lectures non destructives nécessaires s'opère pour chaque image HDR, de sorte que le nombre de poses et les temps d'exposition associés peuvent être optimisés en fonction des différents niveaux de luminosité rencontrés dans la scène à imager.

En outre, un tel procédé de génération d'image HDR repose sur l'utilisation d'une zone mémoire unique, correspondant à une image du capteur, et ne nécessite pas de mémoriser l'ensemble des images successives obtenues par lectures non destructives du capteur d'image, ce qui permet, par rapport aux techniques de l'art antérieur, un gain important, tant en termes d'espace de mémorisation requis et de bande passante entre espace de mémorisation et unité de traitement, que de puissance de calcul nécessaire à la génération de l'image HDR. De plus cette génération à la volée à espace de mémorisation unique permet dans un mode d'utilisation en temps réel d'étendre le nombre d'images, nombre qui peut ainsi être augmenté sans limitation matérielle et donc potentiellement la dynamique imagée. Grâce à un tel procédé, on garde en mémoire un seul plan image, avec mise à jour progressive des pixels pondérés par leur temps de pose associé, au fur et à mesure des lectures NDRO successives.

Ainsi, une représentation de la matrice du capteur est stockée dans une zone mémoire, et est réactualisée à chaque nouvelle image NDRO acquise. Chaque élément de cette zone mémoire stocke la valeur courante de chacun des pixels de la dernière image NDRO lue, ou, si cette valeur a atteint le seuil de sélection de signal dans une image NDRO précédente, la valeur correspondante dans cette image précédente, qui va servir à la reconstruction de l'image HDR. Ces valeurs sont mémorisées en association avec les temps d'exposition des images NDRO dont elles sont extraites.

Selon un aspect avantageux de l'invention, les étapes du procédé nécessaires à la génération de ladite image à grande gamme dynamique mettent en œuvre une mémorisation d'une unique image à un instant donné. Ainsi, dans la zone mémoire, seule une image est mémorisée à chaque instant de la phase de génération de l'image à grande gamme dynamique.

Selon un aspect de l'invention, un tel procédé comprend une étape préliminaire de détermination d'un critère de qualité souhaité pour ladite image à grande gamme dynamique et d'un temps d'exposition maximum dudit capteur. Un tel temps d'exposition maximum du capteur permet de borner dans le temps la fin du processus itératif de génération de l'image HDR.

Selon un mode de réalisation de l'invention, le critère de qualité souhaité est un critère de rapport signal sur bruit des pixels de l'image à grande gamme dynamique.

Ainsi, un tel procédé de génération d'une image HDR repose sur une optimisation du RSB (Ratio Signal sur Bruit), défini selon l'équation (Eq. 9) ci-après, sur un niveau fixé à l'avance dans un temps d'acquisition de l'image HDR aussi court que possible. Le RSB est optimisé au niveau de chaque NDRO et des pixels sélectionnés selon ce critère. Ainsi le RSB final sera optimisé pour chaque pixel sélectionné à chacune de leur NDRO respective et notamment pour les signaux les plus faibles qui ont été sélectionnés et auront conduit à la dernière NDRO (à la condition que le RSB souhaité ait été atteint pour les pixels avec les signaux les plus faibles avant le 'time-out' $t_{out}$, fixé par avance également).

Selon un autre aspect de ce mode de réalisation, l'image NDRO d'indice N, i.e. la dernière image NDRO à utiliser pour la génération d'image HDR, est :

- la première desdites images NDRO successives dans laquelle tous les pixels sont associés à une valeur de signal supérieure ou égale audit seuil de sélection de signal ; ou
- la dernière desdites images NDRO successives, associée audit temps d'exposition maximum dudit capteur, si elle contient au moins un pixel associé à une valeur de signal inférieure audit seuil de sélection de signal.

Ainsi, dès que tous les pixels de l'image ont atteint une valeur supérieure ou égale au seuil de sélection de signal, on cesse les lectures non destructives du capteur, pour reconstruire l'image HDR. A l'inverse, si, à l'issue d'un temps d'exposition maximum préalablement choisi, il existe encore des pixels dont la valeur reste inférieure à ce seuil de sélection de signal, on interrompt néanmoins les lectures non destructives du capteur, pour éviter que le temps de pose ne soit trop important, voire ne dérive vers une valeur infinie, lorsque les conditions d'illumination de la scène ne permettent pas l'atteinte de ce seuil. Pour ces pixels, la valeur retenue lors de la reconstruction de l'image HDR correspond à la valeur de signal dans la dernière image NDRO lue.

Selon un autre aspect de ce mode de réalisation, la génération de l'image à grande gamme dynamique comprend un calcul d'une valeur de signal associée à chaque pixel de l'image à grande gamme dynamique par pondération évaluée, en fonction de la réponse du capteur, de la valeur de signal mémorisée dans ladite zone mémoire pour chacun des pixels par le temps d'exposition associé.

La reconstruction de l'image HDR peut se faire progressivement, au fur et à mesure des différentes lectures NDRO du capteur, à partir des valeurs de chaque pixel sélectionné comme ayant une valeur supérieure au seuil de sélection de signal, pondérées par les temps d'exposition respectifs associés des images NDRO dont ils sont extraits.

Selon un autre aspect, un tel procédé comprend également une détermination préalable d'un temps minimum d'accumulation de charges électriques sur le capteur d'image avant la première lecture non destructive dudit capteur d'image, noté $t_{min}$,

et un tel temps minimum d'accumulation $t_{min}$ satisfait la condition :

$$\frac{t_{min} + (t_{NDRO})}{t_{min}} < \frac{S_{sat}}{S_0}$$

où :

- $t_{NDRO}$ est un temps entre deux itérations successives de lecture non destructive du capteur d'image ;
- $S_{sat}$ est un signal de saturation du capteur d'image ;
- $S_0$ est le signal électronique exploitable le plus faible issu du capteur d'image.

Ce temps $t_{min}$ correspond donc au temps d'accumulation minimal du système. Il est ainsi choisi de façon à éviter toute perte d'information, en s'assurant, dans le cas où un tel procédé est mis en œuvre dans un système comprenant un capteur à réponse linéaire, que l'on reste dans la plage de fonctionnement linéaire du capteur.

En considérant que $t_{min}$ correspond au temps d'accumulation de la première image NDRO, et que toutes les lectures NDRO suivantes ont un temps d'accumulation croissant de façon régulière d'un pas $t_{NDRO}$, la condition imposée au temps d'accumulation $t_{min}$ consiste à s'assurer que le rapport des temps d'accumulation de la deuxième image NDRO ($t_{min}+t_{NDRO}$) et de la première image NDRO ($t_{min}$) est sensiblement le même que la dynamique du capteur d'image à réponse linéaire.

La mise en œuvre d'un tel procédé dans un système d'acquisition comprenant un capteur d'image à réponse mixte linéaire/logarithmique permet de s'affranchir de cette contrainte imposée au temps minimum d'accumulation $t_{min}$, qui peut alors être réduit jusqu'à un coup d'horloge système.

L'invention concerne également un produit programme d'ordinateur comprenant des instructions de code de programme pour la mise en œuvre d'un procédé tel que décrit précédemment, lorsqu'il est exécuté par un processeur.

Un tel programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise également un support d'enregistrement lisible par un ordinateur sur lequel est enregistré un programme d'ordinateur comprenant des instructions de code de programme pour l'exécution des étapes du procédé de génération d'une image à grande gamme dynamique selon l'invention tel que décrit ci-dessus.

Un tel support d'enregistrement peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple un disque dur, ou encore une mémoire flash, telle qu'une clé USB.

D'autre part, un tel support d'enregistrement peut être un support transmissible tel qu'un signal électrique ou optique, qui peut être acheminé via un câble électrique ou optique, par radio ou par d'autres moyens, de sorte que le programme d'ordinateur qu'il contient est exécutable à distance. Le programme selon l'invention peut être en particulier téléchargé sur un réseau par exemple le réseau Internet.

Alternativement, le support d'enregistrement peut être un circuit intégré dans lequel le programme est incorporé, le circuit étant adapté pour exécuter ou pour être utilisé dans l'exécution du procédé de contrôle d'affichage précité.

L'invention concerne encore un système de génération d'une image à grande gamme dynamique d'une scène, à partir d'une pluralité d'images de la scène obtenues par lecture non destructive d'un capteur d'image, appelées images NDRO. Un tel capteur comprend une pluralité de pixels agencés sous forme matricielle, et associés chacun à un élément de conversion photoélectrique permettant de convertir une lumière reçue en charges électriques et d'accumuler les charges électriques pendant un temps d'exposition à la lumière. Un tel système comprend une unité de calcul (processeur, FPGA, ...) adaptée à la mise en œuvre des étapes du procédé de génération d'image à grande gamme dynamique tel que décrit précédemment.

L'invention concerne enfin un système de génération d'une image à grande gamme dynamique d'une scène, à partir d'une pluralité d'images de la scène obtenues par lecture non destructive d'un capteur d'image, appelées images NDRO. Un tel système comprend un capteur comprenant une pluralité de pixels agencés sous forme matricielle, et associés chacun à un élément de conversion photoélectrique permettant de convertir une lumière reçue en charges électriques et d'accumuler les charges électriques pendant un temps d'exposition à la lumière, le capteur étant apte à fonctionner dans un mode de lecture non destructive.

Selon un mode de réalisation de l'invention, un tel système comprend :

- un module d'interface pour saisie par un utilisateur d'un critère de qualité souhaité pour l'image à grande gamme dynamique et d'un temps d'exposition maximum dudit capteur ;
- une unité de calcul (processeur, FPGA, ...) apte à comparer, pour chaque pixel d'une image NDRO, parmi une pluralité d'images NDRO successives délivrées par ledit capteur, une valeur de signal correspondant auxdites charges électriques accumulées par ledit pixel à un seuil de sélection de signal, et à sélectionner ledit pixel si ladite valeur de signal associée audit pixel est supérieure audit seuil de sélection de signal et si ledit pixel n'a pas été précédemment sélectionné dans une image NDRO précédente de ladite pluralité d'images NDRO ;
- une mémoire apte à mémoriser des valeurs de signal associées auxdits pixels sélectionnés desdites images NDRO successives en association avec des temps d'exposition associés auxdites images NDRO ;
- une unité de calcul (processeur, FPGA, ...) configurée pour générer ladite image à grande gamme dynamique à partir desdites valeurs de signal associées auxdits pixels sélectionnés et desdits temps d'exposition mémorisés en association.

Plus généralement, un tel système de génération d'une image à grande gamme dynamique comprend, en combinaison, l'ensemble des moyens nécessaires à la mise en œuvre du procédé de génération d'une image à grande gamme dynamique tel que décrit précédemment, selon toutes ses implémentations et modes de réalisation.

## 4. Liste des figures

D'autres buts, caractéristiques et avantages de l'invention apparaîtront plus clairement à la lecture de la description suivante, donnée à titre de simple exemple illustratif, et non limitatif, en relation avec les figures, parmi lesquelles :

- la **figure 1** illustre sous forme d'organigramme un mode de réalisation d'un procédé adaptatif de génération d'une image HDR à partir d'une pluralité d'images NDRO obtenues par lecture non destructive du capteur d'images ;
- les **figures 2 et 3** proposent deux exemples d'architecture matérielle d'un système de génération d'image HDR mettant en œuvre le procédé illustré en **figure 1.**

## 5. Description détaillée de modes de réalisation de l'invention

Le principe général de l'invention repose sur la reconstruction d'images à grande gamme dynamique (HDR) à partir d'images obtenues par lectures non destructives d'un capteur d'images, selon un procédé adaptatif, permettant d'améliorer sensiblement la vitesse d'acquisition de l'image HDR, et d'optimiser dynamiquement le nombre de lectures non destructives nécessaires, en fonction de la dynamique de l'image HDR visée, et des paramètres de luminosité de la scène à imager.

### 5.1 Notations, définitions et principes

Dans la suite de ce document, on considère que les éléments de conversion photoélectrique sous-jacents aux pixels du capteur du système d'acquisition d'image sont réalisés, par exemple, selon une technologie CMOS (en anglais, « Complementary Metal Oxide Semiconductor »). On rappelle que la technologie CMOS équipe la plupart des systèmes photographiques ou vidéos. Les détecteurs d'images de type CMOS présentent l'avantage de pouvoir être lus dans un mode de lecture dite non destructive, ou NDRO.

Le mode de lecture non destructive permet de lire les charges électriques accumulées par chacun des éléments de conversion photoélectriques du capteur (donc les valeurs de signal associées aux pixels), sans remise à zéro de ces derniers. En d'autres termes, la lecture NDRO permet d'observer la formation d'une image sur le détecteur pendant une pose sans la détruire.

Par « saturation », on entend un état dans lequel la quantité de lumière incidente sur les éléments de conversion photoélectrique du capteur dépasse la quantité maximale, dans la plage de fonctionnement linéaire du détecteur, de charges électriques que ces éléments de conversion peuvent accumuler. Il en résulte un phénomène de surexposition des zones correspondantes de l'image, si l'on se restreint au domaine linéaire des capteurs. Cependant, certains capteurs peuvent exploiter deux réponses, linéaire et logarithmique, simultanément, permettant de lever cette contrainte, notamment dans le choix du temps d'accumulation de la première NDRO.

On propose ci-après quelques notations et définitions qui seront utilisées dans la suite de ce document.

- ADU : pour l'anglais « Analog to Digital Unit » désigne une unité analogique-numérique, correspondant à la quantité de signal analogique en entrée d'un convertisseur analogique numérique, pour qu'il délivre une unité en sortie. Ainsi, par la connaissance du gain système (exprimé en e-/ADU (électrons par ADU) par exemple), on peut remonter à la quantité d'électrons issus du détecteur, et par la connaissance du rendement quantique, on peut remonter à la quantité de photons incident.

- $Q_\lambda$ : rendement quantique du système, défini comme le ratio entre le nombre de photons, à une longueur d'onde $\lambda$ donnée, tombés sur le capteur par rapport au nombre de charges électriques créées par les éléments de conversion photoélectriques du capteur et exploitables comme signal par le système électronique de lecture du système d'acquisition d'images. Les charges électriques créées par les éléments de conversion photoélectrique du détecteur, ou capteur, à partir de photons incidents mais 'perdues' ensuite dans le bruit de lecture global sont donc ici déduites.

- $F_{max,\lambda}$ : flux lumineux maximal incident à une longueur d'onde $\lambda$ donnée, qui peut être exprimé par exemple en photons par seconde.

- $F_{min,\lambda}$ : flux lumineux minimal incident à une longueur d'onde $\lambda$ donnée, qui peut être exprimé par exemple en photons par seconde.

- $T_{timeout}$ : Temps d'exposition maximum du capteur pour une image, exprimé en secondes. Ce temps d'exposition maximum, également appelé temps de pose maximum, est déterminé avant toute acquisition d'image, et peut être ajusté avant chaque nouvelle phase de génération d'image HDR.

- $n_{timeout}$ : index de la n$^{ième}$ image NDRO, associée à un temps d'exposition égal au temps d'exposition maximum $T_{timeout}$.

- $T_P$ : temps de pose pour une image HDR à générer, exprimé en secondes, au cours duquel sont effectuées les lectures non destructives du capteur. Le temps de pose $T_P$ est inférieur ou égal au temps d'exposition maximum $T_{timeout}$ et correspond au temps d'exposition équivalent de la dernière image NDRO utilisée pour la reconstruction de l'image HDR.

- $t_{min}$ : temps d'accumulation minimal du système d'acquisition d'images, correspondant au temps minimum d'accumulation jusqu'à la première lecture non destructive possible du capteur, exprimé en secondes.

- $t_{accu1}$ : temps d'accumulation jusqu'à la première image NDRO utile à la reconstruction HDR. Ce temps $t_{accu1}$ correspond au temps d'exposition associé à la première des images NDRO successives utilisée pour la reconstruction de l'image HDR.

- $t_{NDRO}$ : temps de lecture, exprimé en secondes, d'une image NDRO.

- $S_{min}$ : signal le plus faible sur l'image HDR finale générée selon un mode de réalisation de la présente invention.

- $s_{min}$ : signal le plus faible dû au flux incident le plus faible sur les différentes images NDRO successives obtenues par lecture non destructive du capteur du système d'acquisition d'images.

- $S_{max}$ : signal le plus fort sur l'image HDR finale générée selon un mode de réalisation de la présente invention.

- $s_{max}$ : signal le plus fort dû au flux incident le plus fort sur les différentes images NDRO successives obtenues par lecture non destructive du capteur du système d'acquisition d'images.

- $S_{sat}$ : signal de saturation du capteur (imposé par le premier élément saturé dans le détecteur: pixel, chaîne de conversion de charge et/ou d'amplification ...)

- $S_0$ : signal correspondant au signal électronique exploitable hors bruit le plus faible issu du détecteur. C'est typiquement le signal dont le niveau correspond au bruit de lecture du détecteur (ou plus généralement du système imageur).

- $S_{sel}$ : seuil de sélection de signal pour la sélection de la valeur des pixels pour la reconstruction HDR selon un deuxième mode de réalisation de l'invention décrit ci-après.

- $N_r$ : bruit de lecture du détecteur, ou plus généralement du système imageur.

- $N_T$ : Bruit thermique associé au signal thermique du détecteur (accumulé pendant la pose).

- $N_p$ : Bruit de photon associé au signal lumineux accumulé pendant la pose. Les bruits $N_r$, $N_T$, et $N_p$ sont généralement exprimés en électrons ramenés à la sortie du détecteur, ou en ADU avec la connaissance du Gain système en e-/ADU (électrons par ADU).

- $P_{i,j}^{NDRO_n}$ : Valeur du signal associé au pixel de coordonnées (i,j) dans la matrice du capteur, issu de l'image NDRO de rang n NDRO$_n$, où $0 \leq n \leq n_{timeout}$.

- $RSB_{i,j}^{NDRO_n}$ : Rapport Signal sur Bruit du pixel de coordonnées (i,j) issu de l'image NDRO de rang n $NDRO_n$, où $0 \leq n \leq n_{timeout}$.

On notera que les différents signaux $S_{max}$, $s_{max}$, $S_{min}$, $s_{min}$, $S_{sat}$, $S_{sel}$, $S_0$ sont décrits, ci-dessus, sans unité associée. En effet, s'ils sont vus après conversion analogique-numérique, ils seront exprimés en unités ADU. En revanche, s'ils sont considérés avant l'étape de conversion analogique-numérique, ils seront alors exprimés dans l'unité de la grandeur physique (analogique) qui les caractérise : Volts ou Ampères.

Sur la base de ces notations, la dynamique D de l'image HDR à générer peut s'exprimer comme le rapport :

$$D = \frac{S_{max}}{S_{min}} = \frac{s_{max}/t_{accu1}}{s_{min}/T_p} \qquad (Eq1)$$

avec

$$s_{min} = T_P \times F_{min,\lambda} \times Q_\lambda \qquad (Eq2)$$

$$s_{max} = t_{accu1} \times F_{max,\lambda} \times Q_\lambda \qquad (Eq3)$$

On en déduit donc la relation :

$$D = \frac{F_{max\lambda}}{F_{min\lambda}} \qquad (Eq4)$$

et:

$$t_{accu1} = t_{min} + (n_1 \times t_{NDRO}) \qquad n_1 \geq 0 \qquad (Eq5)$$

$$T_p = t_{min} + ((n_1 + n_2) \times t_{NDRO}) \qquad n_2 \geq n_1 \qquad (Eq6)$$

où l'indice $n_1$ désigne l'indice, parmi une succession d'images NDRO obtenues par lecture non destructive du capteur d'image, de la première image NDRO à utiliser pour générer l'image à grande gamme dynamique HDR, et où l'indice $n_2$ désigne le nombre d'images NDRO prises depuis la première image utile d'indice $n_1$, de sorte que $n_1+n_2$ est l'indice, parmi la succession d'images NDRO obtenues par lecture non destructive du capteur d'image, de la dernière image NDRO à utiliser pour générer l'image à grande gamme dynamique HDR.

La dynamique du système d'acquisition d'images (avec au premier chef le détecteur) est finie, elle est limitée aux faibles valeurs par le niveau de bruit le plus fort ($S_0$) et aux fortes valeurs par le niveau de saturation du système $S_{sat}$ (au premier élément de la chaîne qui sature). Les flux lumineux incidents qui peuvent être rendus sur une image 'brute' (non HDR) sont ceux qui, intégrés pendant un temps de pose t, donnent un signal Sig qui répond à $S_0 < Sig < S_{sag}$. Les flux lumineux étant fixés par la scène à imager et le diaphragme du chemin optique qui sont, *a priori,* non modifiables, les paramètres ajustables sont donc les différents temps de poses avec en particulier $T_P$, qui correspond au temps d'exposition associé à la dernière image NDRO utilisée pour générer l'image HDR, et donc au temps de pose de cette image HDR, et $t_{accu1}$, qui, comme indiqué ci-avant, correspond au temps d'exposition associé à la première image NDRO utilisée pour générer l'image HDR.

Ces deux paramètres ajustables le sont cependant dans certaines limites, à savoir :

- $t_{accu1} \geq t_{min}$ : en effet, le temps d'exposition associé à la première image NDRO à utiliser pour générer l'image HDR ne peut être inférieur au temps d'accumulation minimal du système d'acquisition d'images ; et

- $$T_p \leq T_{timeout} \qquad (Eq7)$$

En effet, le temps de pose associé à l'image HDR est borné par le temps d'exposition maximum défini au préalable.

On notera que les temps $t_{min}$ et $T_{timeout}$ sont fixes pour une séquence de prises de vues HDR, mais peuvent être modifiés pour être plus adaptés aux conditions de luminosité de la scène à imager. Néanmoins, $T_{timeout}$ doit être suffisamment 'court' pour que le bruit associé au signal thermique accumulé pendant $T_{timeout}$ ne soit pas supérieur au signal minimum à détecter. La température, en fonctionnement, du détecteur étant connue, le signal thermique (en électrons/seconde créés, accumulés puis lus) est connu, son bruit associé aussi. Le signal thermique (appelé aussi 'bruit' thermique) en fonction de la température, est une donnée constructeur du détecteur.

En outre, les inventeurs de la présente demande de brevet ont établi que certaines contraintes supplémentaires devaient être respectées par le temps minimum d'accumulation du système $t_{min}$, afin d'éviter toute perte d'information dans un système à réponse linéaire, et ce, afin de ne pas sortir de la plage de fonctionnement linéaire du capteur.

Ainsi, dans le cas limite où $t_{accu1} = t_{min}$, et où le temps d'accumulation associé à la n$^{ième}$ image NDRO est $t_{accu\_n} = t_{accu1} + ((n - 1) \times t_{NDRO})$, i.e. que les temps d'accumulation associés aux différentes images NDRO successives croissent d'un pas $t_{NDRO}$, une contrainte supplémentaire doit être respectée entre le temps d'accumulation de la première et de la deuxième images NDRO utiles, sous la forme :

$$\frac{t_{accu\_2}}{t_{accu1}} < \frac{S_{sat}}{S_0}$$

soit (Eq. 8) :

$$\frac{t_{min} + (t_{NDRO})}{t_{min}} < \frac{S_{sat}}{S_0}$$

En d'autres termes, pour éviter toute perte d'information, il convient, pour les systèmes avec des capteurs à réponse linéaire, de satisfaire la condition de l'équation Eq. 8. A titre alternatif, il est possible d'utiliser des systèmes avec des capteurs à réponses mixtes linéaires/logarithmiques, qui lèvent le verrou du temps d'accumulation relatif entre la première et la deuxième images NDRO utiles, $t_{accu1}$ et $t_{accu\_2}$, ce qui permet de réduire le temps minimum d'accumulation du système d'acquisition $t_{min}$ jusqu'au temps minimum physique de l'horloge système (i.e. jusqu'à un coup d'horloge).

### 5.2 Description d'un mode de réalisation

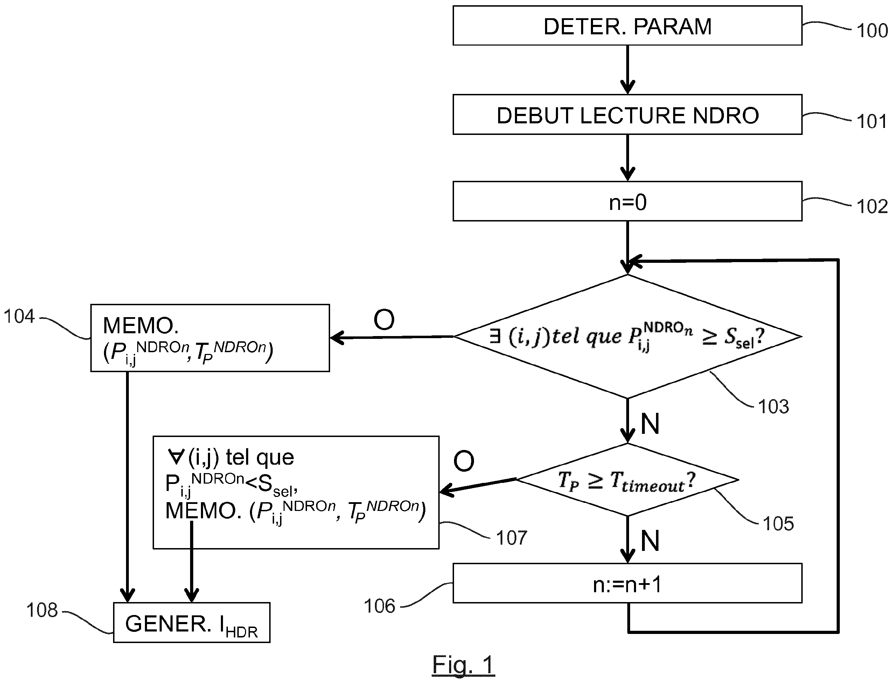

Ces principes ayant été rappelés, on présente désormais, en relation avec la **figure 1,** un organigramme d'une méthode de génération d'une image à grande gamme dynamique HDR selon un mode de réalisation de la présente invention.

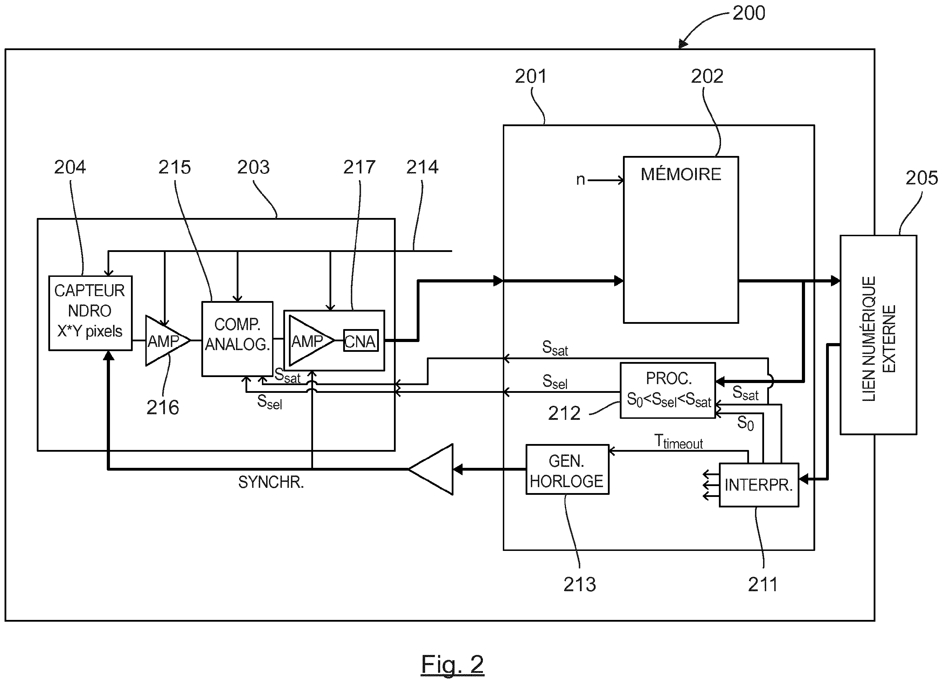

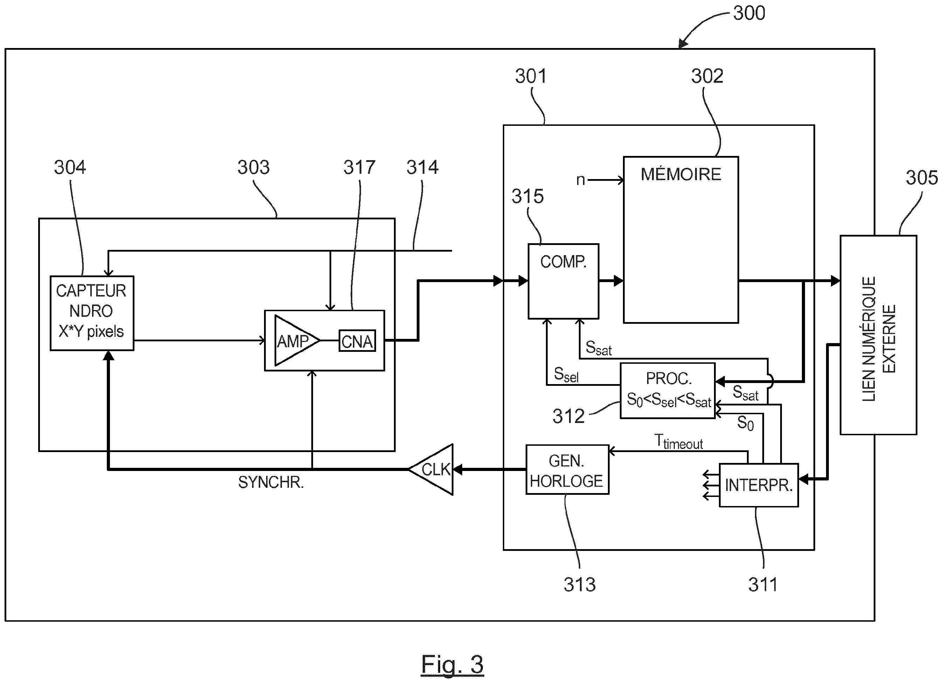

Une telle méthode peut être mise en œuvre dans tout type de système d'acquisition d'images, qu'il s'agisse d'images fixes ou vidéo. Un tel système est notamment décrit plus en détail ci-après en relation avec les **figures 2 et 3.**

Selon ce mode de réalisation, on procède à une sélection en temps réel des valeurs des pixels à utiliser pour la reconstruction de l'image HDR finale avec uniquement la mémorisation d'une seule image à tout instant de la génération.

En effet, à partir de la première image NDRO lue (lecture effectuée après le temps d'accumulation $t_{min}$), il faut déterminer les pixels, issus de cette première image NDRO et des images NDRO qui suivent, qui seront pertinents pour la reconstruction HDR. En effet une valeur d'un pixel issu de la n$^{ième}$ image NDRO, $P_{i,j}^{NDRO_n}$, ne sera exploitable que si au minimum $S_0 < P_{i,j}^{NDRO_n} < S_{sat}$ où $S_0$ est le signal correspondant au signal électronique exploitable le plus faible issu du détecteur (typiquement, le signal dont le niveau correspond au bruit de lecture du détecteur ou plus généralement du système imageur), et où $S_{sat}$ est le signal de saturation du capteur (imposé par le premier élément saturé dans le détecteur : pixel, chaîne de conversion de charge et/ou d'amplification...). Dans ce mode de réalisation, on cherche à optimiser le RSB (Ratio Signal sur Bruit) sur un niveau fixé à l'avance dans le temps le plus court, n'excédant pas un temps maximum d'exposition ($T_{timeout}$) fixé lui aussi à l'avance.

$$RSB_{i,j}^{NDRO_n} = \frac{P_{i,j}^{NDRO_n}}{\sqrt{N_r^2 + N_T^2 + N_p^2}} \qquad (Eq. 9)$$

$$\text{avec } N_{tot} = \sqrt{N_r^2 + N_T^2 + N_p^2} \text{ soit } RSB_{i,j}^{NDRO_n} = \frac{P_{i,j}^{NDRO_n}}{N_{tot}} \qquad (Eq. 10)$$

La valeur du bruit associé à la valeur d'un pixel évolue en racine de la valeur du signal accumulé sur le pixel. Pour maximiser le ratio signal sur bruit $RSB_{i,j}$ d'un pixel de coordonnées (i,j), il faut accumuler le plus de signal possible pour augmenter sa valeur $P_{i,j}$, c'est-à-dire augmenter au maximum son temps de pose : en effet, $P_{i,j}$ évolue en fonction du temps de pose et le bruit associé évolue, lui, en racine de $P_{i,j}$, donc beaucoup moins rapidement. Dans la plupart des cas, cette fonction est linéaire (à flux lumineux incident constant pendant la pose). Cela permet l'exploitation directe des images NDROs par une pondération simple (Eq. 13, voir ci-après). Dans le cas d'un comportement non linéaire, il faut obtenir la fonction de réponse du détecteur (et/ou du système imageur) pour chaque pixel, lors de la calibration du détecteur et/ou du système imageur associé. Cette réponse pour chaque pixel permettra de pondérer la valeur de chaque pixel, et ainsi de retomber sur l'exploitation linéaire décrite à l'équation (Eq. 13). Le RSB est optimisé au niveau de chaque NDRO et des pixels sélectionnés selon ce critère. Ainsi le RSB final sera optimisé pour chaque pixel sélectionné à chacune de leur NDRO respective et notamment pour les signaux les plus faibles qui ont été sélectionnés et auront conduit à la dernière NDRO (à la condition que le RSB souhaité ait été atteint pour les pixels avec les signaux les plus faibles avant le 'time-out' $t_{out}$, fixé par avance également).

Ainsi qu'illustré en **figure 1,** au cours d'une étape préalable référencée 100, on détermine la valeur de certains paramètres ajustables du système, parmi lesquels :

- le temps minimum d'accumulation du système d'acquisition $t_{min}$;
- le temps maximum d'exposition du capteur $T_{timeout}$;
- le rapport signal sur bruit RSB souhaité pour chacun des pixels et surtout pour les pixels avec les signaux les plus faibles, pour l'image HDR à générer (voir Eq. 10) ;
- la valeur d'un seuil de sélection de signal $S_{sel}$, qui est défini tel que $S_{sel} < S_{sat}$ (et $S_{sel} > S_0$).

La valeur de ces paramètres est notamment établie en fonction des conditions de luminosité (flux lumineux) de la scène à imager. Ainsi, le temps minimum d'accumulation du système d'acquisition $t_{min}$, qui est fixé avant la prise de vue, peut être optimisé, avant la prise, au fort flux lumineux de la scène. Pour un système d'acquisition avec un capteur à réponse linéaire, ce temps minimum d'accumulation $t_{min}$ doit cependant respecter la contrainte de l'équation Eq. 8:

$\frac{t_{min} + (t_{NDRO})}{t_{min}} < \frac{S_{sat}}{S_0}$, et ce afin de rester dans la plage de fonctionnement linéaire du capteur, et éviter toute perte d'information. Pour un système d'acquisition avec un capteur à réponse mixte linéaire/logarithmique, il est possible de réduire le temps $t_{min}$ le cas échéant jusqu'au temps minimum de l'horloge système.

De même, le seuil de sélection de signal $S_{sel}$ peut être modifié pour s'adapter au mieux aux conditions d'illumination de la scène, ou bien pour optimiser et privilégier le temps de pose $T_P$, ou encore optimiser et privilégier le RSB final pour les signaux les plus faibles etc.

Cette étape préalable référencée 100 doit être mise en œuvre à l'initialisation du système d'acquisition d'images. Elle peut être réitérée à chaque nouvelle prise d'images en vue d'une reconstruction HDR. A titre alternatif, les mêmes paramètres peuvent être conservés pour plusieurs captures d'images HDR successives. On peut également envisager que certains de ces paramètres restent inchangés d'une prise de vue HDR à la suivante, tandis que d'autres sont adaptés à chaque nouvelle prise de vue.

Au cours d'une étape référencée 101, on débute une succession de lectures non destructives du capteur, qui délivrent chacune une image dite NDRO d'indice n, n étant initialisé à 0 (étape référencée 102).

Pour chaque image NDRO courante d'indice n, la valeur du pixel $P_{i,j}^{NDRO_n}$ est sélectionnée pour être utilisée pour la reconstruction de l'image HDR finale à partir du moment où :

$$P_{i,j}^{NDRO_n} \geq S_{sel} \qquad (Eq. 11)$$

Cette comparaison de la valeur des pixels $P_{i,j}^{\text{NDRO}_n}$ de l'image NDRO$_n$ courante au seuil de sélection de signal S$_{\text{sel}}$ est effectuée au cours d'une étape référencée 103. Lorsque la condition est vérifiée, le pixel sélectionné est mémorisé (étape référencée 104), en association avec le temps d'exposition de l'image NDRO$_n$ dont il est extrait, noté t$_{i,j}^{\text{NDROn}}$. Il servira alors à la génération de l'image HDR référencée 108.

Plus S$_{\text{sel}}$ est élevé (tout en vérifiant S$_{\text{sel}}$ < S$_{\text{sat}}$) et plus les pixels $P_{i,j}^{\text{NDRO}_n}$ dont la valeur satisfait la condition de l'équation Eq. 11, dans un temps inférieur à T$_{\text{timeout}}$, ont un RSB élevé.

La première image NDRO dans laquelle au moins un pixel vérifie la condition de l'équation Eq. 11 est la première image de la succession d'images NDRO qui sera utilisée pour la reconstruction de l'image HDR, référencée 108.

Si aucun pixel de l'image NDRO$_n$ courante ne satisfait la condition de l'équation Eq. 11, on vérifie au cours d'une étape référencée 105, si le temps d'exposition t$_{i,j}^{\text{NDROn}}$ associé à l'image NDRO$_n$ courante n'atteint pas le temps d'exposition maximum déterminé au cours de l'étape préliminaire 100.

Si ce n'est pas le cas, l'indice de l'image NDRO courante est incrémenté au cours d'une étape référencée 106 (n :=n+1), et les lectures non destructives du capteur se poursuivent.

Si en revanche, le résultat de la comparaison de l'étape référencée 105 est positif, cela signifie que pour certains pixels de l'image NDRO associée au temps d'exposition maximum, $P_{i,j}^{\text{NDRO}_n}$ reste inférieur à S$_{\text{sel}}$. Dans ce cas, le pixel, parmi les n$_2$ images NDRO prises, qui donnera le meilleur RSB, sera celui de la dernière image NDRO prise, associée au temps d'exposition maximum prédéfini.

On mémorise alors, au cours d'une étape référencée 107, les valeurs des pixels de cette dernière image NDRO utile, en association avec le temps d'exposition maximum qui leur est associé, dont la valeur est restée inférieure au seuil de sélection S$_{\text{sel}}$.

En effet, si pour au moins certains pixels du capteur la condition de l'équation Eq. 11 n'est pas vérifiée avant la fin du temps de pose T$_P$, alors c'est la dernière valeur de pixel issue de la dernière image NDRO prise qui sera conservée, en association avec son temps d'exposition (correspondant ici à T$_P$).

Les itérations de lecture non destructive du capteur peuvent être interrompues lorsque tous les pixels du capteur ont atteint une valeur de signal supérieure ou égale au seuil de sélection de signal S$_{\text{sel}}$.

Chaque pixel retenu pour la reconstruction de l'image HDR sera donc issu d'une des images NDRO prises entre t$_{\text{min}}$ et T$_P$ avec $T_p \leq T_{\text{timeout}}$, il sera caractérisé par sa valeur $P_{i,j}^{\text{NDRO}_n}$ et son temps d'exposition

$$t_{i,j}^{\text{NDRO}_n} = t_{\text{min}} + ((n-1) \times t_{\text{NDRO}}) \text{ (Eq. 12)}.$$ (Eq. 12).

La génération de l'image HDR, référencée 108, est effectuée à partir des valeurs des pixels mémorisées au cours des étapes référencées 104 et 107, pondérées par leur temps d'exposition respectif :

$$P_{i,j}^{\text{HDR}} = \frac{P_{i,j}^{\text{NDRO}_n}}{t_{i,j}^{\text{NDRO}_n}} \quad \text{(Eq. 13)}$$

On notera que, dans le cas où le temps d'acquisition t$_{\text{min}}$ ne respecte pas la contrainte de l'équation Eq. 8, tous les pixels de l'image reconstruite HDR finale, dont la valeur $P_{i,j}^{\text{HDR}} = \frac{P_{i,j}^{\text{NDRO}_n}}{t_{i,j}^{\text{NDRO}_n}}$ est telle que $\frac{S_0}{t_{\text{min}}} < P_{i,j}^{\text{HDR}} < \frac{S_{\text{sat}}}{t_{\text{accu\_2}}}$, ne contiendront pas d'information pertinente.

Dans un mode de réalisation, une 'image' de la matrice du détecteur est stockée dans une mémoire et est réactualisée à chaque nouvelle image NDRO prise. Chaque élément de cette zone mémoire stocke la valeur $P_{i,j}^{\text{NDRO}_n}$ (courante lors de la dernière image NDRO lue) pondérée par son temps d'exposition correspondant $t_{i,j}^{\text{NDRO}_n}$. Pour les pixels dont la valeur a atteint le seuil de sélection S$_{\text{sel}}$ dans une image NDRO précédente, les éléments de la zone mémoire ne sont bien sûr pas réactualisés, et restent figés à la valeur mémorisée au cours de l'étape référencée 104.

Ainsi, lors de la première lecture NDRO de l'étape référencée 101, la zone mémoire représentative de la matrice du détecteur est initialisée avec les valeurs des pixels $P_{i,j}^{\mathrm{NDRO}_0}$ de la première image NDRO d'indice n=0. Ceux de ces pixels dont la valeur est supérieure au seuil de sélection du signal $S_{sel}$ sont mémorisés de façon définitive dans la zone mémoire, sans qu'ils ne puissent plus être actualisés au cours des lectures NDRO suivantes.

La reconstruction de l'image à grande gamme dynamique HDR s'opère donc progressivement, au fur et à mesure des différentes lectures non destructives du capteur effectuées durant le temps de pose $T_P$.

Ce mode de réalisation, illustré en **figure 1,** permet l'adaptation en temps réels des temps d'expositions (avec toujours le prérequis de l'équation Eq. 7). Ce mode de réalisation n'impose pas de déterminer les images NDRO aux instants $T_p$ et $t_{accu1}$, l'image HDR se construisant d'elle-même à chaque nouvelle image NDRO, jusqu'à un optimum préalablement défini. Par ailleurs, cette méthode fonctionne de manière optimale avec une et une seule 'image' de la matrice du détecteur stockée en mémoire. Cette matrice, en mémoire, est réactualisée à chaque nouvelle image NDRO prise. Chaque élément, de cette matrice, stocke une valeur, du pixel, que ce soit courante lors de la dernière image NDRO lue ou bien de la $n^{\mathrm{ième}}$ NDRO, et est pondérée par son temps d'exposition respectif.

Ce procédé est donc particulièrement avantageux en termes d'espace mémoire requis, et de capacité de calcul nécessaire pour la génération de l'image HDR. Contrairement à certaines méthodes de l'état de l'art, il n'est pas nécessaire d'accéder à plusieurs NDRO simultanément. Par conséquent, lors d'une génération HDR en temps réel, le nombre de NDRO n'est alors pas limité par le système.

On notera par ailleurs que, dans le cas d'un système avec capteur à réponse mixte linéaire/logarithmique, il convient d'avoir une calibration de la réponse logarithmique et de la zone de transition linéaire/logarithmique, afin de pondérer la valeur de chaque pixel, et ainsi retomber sur l'exploitation linéaire décrite par l'équation Eq. 13. Par ailleurs, dans ce cas également, le seuil de sélection des pixels doit être adapté à la zone de fonctionnement du capteur. Ainsi, pour les deux premières images NDRO, le seuil de sélection $S_{sel}$ pourra exploiter la partie logarithmique du fonctionnement du capteur, en étant tel que $S_{sel} > S_{sat\_lin}$, où $S_{sat\_lin}$ est le niveau de signal maximum auquel le détecteur linéaire/logarithmique offre une réponse linéaire. Étant dans une réponse logarithmique, il n'y a en effet plus à ce moment de limite de saturation maximum pertinente. Au-delà de la deuxième image NDRO, toutes les images NDRO suivantes étant lues après un temps d'accumulation croissant régulièrement d'un pas $t_{\mathrm{NDRO}}$, on se trouve dans la plage de fonctionnement linéaire du capteur. On a alors $S_{sel} \leq S_{sat\_lin}$, où la valeur $S_{sat\_lin}$ devient équivalente à la valeur $S_{sat}$ du signal de saturation du capteur, évoquée précédemment dans le présent document.

### 5.3 Exemples de systèmes de génération d'image HDR

On présente désormais, en relation avec les **figures 2 et 3,** deux exemples d'architecture matérielle d'un système de génération d'image HDR (200, 300) mettant en œuvre le procédé décrit ci-avant en relation avec la **figure 1.**

Les éléments communs aux **figures 2 et 3** portent les mêmes références numériques, et sont décrits brièvement ci-après.

Un tel système de génération d'images HDR 200, 300 comprend les éléments suivants, qui sont reliés les uns aux autres par un bus de données et d'adresses :

- une unité de traitement et de contrôle numérique 201, 301, qui peut être, par exemple, un microprocesseur, un FPGA (pour l'anglais « Field-Programmable Gate Array »), un DSP (pour l'anglais « Digital Signal Processor »), un GPU (pour l'anglais « Graphics Processing Unit ») ;
- une mémoire 202, 302 ;
- une interface utilisateur, non représentée, reliée au processeur 201, 301 par un lien numérique externe 205, 305 de type Ethernet, USB, Cam Link...
- un module de traitement analogique 203, 303, comprenant notamment un capteur 204, 304 d'image comprenant une pluralité de pixels agencés sous forme matricielle, et associés chacun à un élément de conversion photoélectrique permettant de convertir une lumière reçue en charges électriques et d'accumuler ces charges électriques pendant un temps d'exposition à la lumière. Ce capteur est apte à fonctionner dans un mode de lecture non destructive.

Un tel système 200, 300 comprend également, classiquement, une mémoire de type ROM (Read Only Memory) qui comprend au moins un programme et différents paramètres nécessaires à l'exécution du procédé selon un mode de réalisation de l'invention. Lorsqu'il est mis sous tension, le processeur charge le programme dans une mémoire de type RAM (« Random Access Memory ») et exécute les instructions correspondantes.

Le système 200, 300 comprend également une source d'alimentation électrique, non représentée, par exemple sous forme de batterie, qui fournit notamment les différents signaux d'alimentation 214, 314.

L'interface utilisateur permet à l'utilisateur de choisir les paramètres déterminés au cours de l'étape référencés 100 sur la **figure 1.** Ils alimentent un module 211, 311 *(« User external Controls & Values interpreter »,* en français *« module d'interprétation des valeurs et commandes externes utilisateur »),* dans lequel ils sont mémorisés, et qui est apte à les fournir aux autres éléments du système 200, 300. Ce module référencé 211, 311 stocke notamment :

- le temps d'exposition maximum du capteur $T_{timeout}$;
- le signal de saturation $S_{sat}$;
- le signal minimum $S_0$.

Un processeur 212, 312 est configuré pour calculer automatiquement le seuil de sélection de signal $S_{sel}$, à partir du signal de saturation $S_{sat}$, du signal minimum $S_0$, et d'informations issues de la prise d'image HDR précédente, tel que $S_0 < S_{sel} < S_{sat}$.

Le temps d'exposition maximum du capteur $T_{timeout}$ est également transmis à un générateur d'horloge 213, 313, destiné à générer et piloter les différents signaux d'horloge synchrones nécessaires au fonctionnement du module de traitement analogique 203, 303.

La mémoire 202, 302, comprend plusieurs cellules mémoires (i,j), qui contiennent chacune la valeur du pixel $P_{i,j}^{\text{NDRO}_n}$ sélectionnée au cours de l'étape référencée 104 ou 107 sur la **figure** 1. Chaque cellule mémoire mémorise également l'indice n de l'image NDRO courante dont cette valeur de pixel est extraite. Le temps d'exposition associé au pixel est $n*t_{\text{NDRO}}$.

A chaque lecture non-destructive du capteur 204, 304, ce dernier délivre un signal analogique, représentant la valeur des charges électriques accumulées par chacun des pixels du capteur.

Comme illustré précédemment en relation avec la **figure 1,** les valeurs des pixels $P_{i,j}^{\text{NDRO}_n}$ sont testées par rapport au seuil de sélection de signal $S_{sel}$ *(Threshold Value)* simplement par comparaison de niveaux (de tension par exemple).

Dans l'exemple de la **figure 2,** cette comparaison s'effectue, de manière très simple, analogiquement, par l'utilisation de comparateurs 215. Après amplification 216, les valeurs de pixel véhiculées par le signal analogique issu du capteur 604 sont comparées au seuil de sélection de signal $S_{sel}$ *(Threshold Value)* et au signal de saturation $S_{sat}$ *(Saturation Value)*. Après amplification et conversion analogique numérique 217, les pixels dont la valeur est supérieure au seuil de sélection $S_{sel}$ doivent être mémorisés, et sont donc transmis par un bus vers la mémoire 202.

Par sa simplicité, ce prétraitement analogique (pour l'aspect adaptatif de ce procédé de reconstruction HDR par image NDRO) peut être intégré directement, 'On Chip', au sein du capteur, pour des 'clusters' de pixels, ou bien directement au sein de chaque pixel dans une structure 3D-CMOS par exemple.

Dans l'exemple de la **figure 3** au contraire, cette comparaison s'effectue de manière déportée au sein de l'unité de traitement numérique 301, dans un module comparateur 315. Ainsi, le signal analogique délivré par le capteur 304 est amplifié et converti en signal numérique (module 317), avant d'être fourni en entrée du module comparateur 315, qui compare la valeur numérique de signal associé à chaque pixel au seuil de sélection de signal $S_{sel}$ et au signal de satruration $S_{sat}$, et sélectionne ceux qui doivent être mémorisés dans la mémoire 302, en vu de leur utilisation pour la reconstruction de l'image HDR.

**Revendications**

1.  Procédé de génération d'une image à grande gamme dynamique d'une scène, à partir d'une pluralité d'images de ladite scène obtenues par lecture non destructive d'un capteur d'image, appelées images NDRO,
    ledit capteur (204, 304) comprenant une pluralité de pixels agencés sous forme matricielle, et associés chacun à un élément de conversion photoélectrique permettant de convertir une lumière reçue en charges électriques et d'accumuler lesdites charges électriques pendant un temps d'exposition à la lumière, le procédé comprenant :

    - une première lecture non destructive dudit capteur d'image, délivrant une première image NDRO courante d'indice n=0, et une mémorisation de ladite première image, au sein d'une zone mémoire, en association avec un temps d'exposition associé à ladite première image ; et **caractérisé en ce que** :
    - pour chaque pixel de ladite première image, une comparaison d'une valeur de signal correspondant auxdites charges électriques accumulées par ledit pixel à un seuil de sélection de signal, et une sélection dudit pixel si ladite valeur de signal associée audit pixel est supérieure audit seuil de sélection de signal ;
    - au moins une itération des étapes successives suivantes, pour n entier, n variant de 1 à N :

13

∘ une lecture non destructive dudit capteur d'image, délivrant une image NDRO courante d'indice n ;

∘ une actualisation de ladite zone mémoire par mémorisation, pour chaque pixel de ladite image NDRO courante d'indice n non précédemment sélectionné dans une image NDRO précédant ladite image NDRO courante, d'une valeur de signal associée audit pixel, en association avec un temps d'exposition associé à ladite image NDRO courante d'indice n ;

∘ pour chaque pixel de ladite image NDRO courante d'indice n, une comparaison d'une valeur de signal correspondant auxdites charges électriques accumulées par ledit pixel audit seuil de sélection de signal, et une sélection dudit pixel si ladite valeur de signal associée audit pixel est supérieure audit seuil de sélection de signal ;

une génération (108) de ladite image à grande gamme dynamique à partir des valeurs de signal mémorisées, pondérées par lesdits temps d'exposition associés desdites valeurs de signal associées auxdits pixels sélectionnés et desdits temps d'exposition mémorisés en association.

2. Procédé de génération d'une image à grande gamme dynamique selon la revendication 1, **caractérisé en ce que** les étapes dudit procédé nécessaires à ladite génération de ladite image à grande gamme dynamique mettent en œuvre une zone mémoire unique correspondant à une image du capteur, les étapes dudit procédé mettant en œuvre une mémorisation d'une unique image à un instant donné.

3. Procédé de génération d'une image à grande gamme dynamique selon la revendication 1 ou 2, **caractérisé en ce qu'**il comprend une étape préliminaire de détermination (100) d'un critère de qualité souhaité pour ladite image à grande gamme dynamique et d'un temps d'exposition maximum dudit capteur.

4. Procédé de génération d'une image à grande gamme dynamique selon la revendication 3, **caractérisé en ce que** ledit critère de qualité souhaité est un critère de rapport signal sur bruit des pixels de ladite image à grande gamme dynamique.

5. Procédé de génération d'une image à grande gamme dynamique selon la revendication 3 ou 4, **caractérisé en ce que** ladite image NDRO d'indice N est :

- la première desdites images NDRO successives dans laquelle tous les pixels sont associés à une valeur de signal supérieure ou égale audit seuil de sélection de signal ; ou
- une image NDRO, associée audit temps d'exposition maximum dudit capteur, si elle contient au moins un pixel associé à une valeur de signal inférieure audit seuil de sélection de signal.

6. Procédé de génération d'une image à grande gamme dynamique selon l'une quelconque des revendications 1 à 5, **caractérisé en ce que** ladite génération (108) de ladite image à grande gamme dynamique comprend un calcul d'une valeur de signal associée à chaque pixel de ladite image à grande gamme dynamique par pondération évaluée, en fonction de la réponse du capteur, de ladite valeur de signal mémorisée dans ladite zone mémoire pour chacun desdits pixels par ledit temps d'exposition associé.

7. Procédé de génération d'une image à grande gamme dynamique selon l'une quelconque des revendications 1 à 6, **caractérisé en ce qu'**il comprend également une détermination préalable d'un temps minimum d'accumulation de charges électriques sur le capteur d'image avant ladite première lecture non destructive dudit capteur d'image, noté $t_{min}$,
et **en ce que** ledit temps minimum d'accumulation $t_{min}$ satisfait la condition :

$$\frac{t_{min} + (t_{NDRO})}{t_{min}} < \frac{S_{sat}}{S_0}$$

où :

• $t_{NDR0}$ est un temps entre deux desdites itérations successives de lecture non destructive dudit capteur d'image ;
• $S_{sat}$ est un signal de saturation dudit capteur d'image ;
• $S_0$ est un signal électronique exploitable, hors bruit, le plus faible issu dudit capteur d'image.

8. Produit programme d'ordinateur comprenant des instructions de code de programme pour la mise en œuvre d'un procédé selon l'une quelconque des revendications 1 à 7, lorsqu'il est exécuté par un processeur.

9. Support d'enregistrement lisible par un ordinateur sur lequel est enregistré un programme d'ordinateur comprenant des instructions de code de programme pour l'exécution des étapes du procédé de génération d'une image à grande gamme dynamique selon l'une quelconque des revendications 1 à 7.

10. Système de génération d'une image à grande gamme dynamique d'une scène, à partir d'une pluralité d'images de ladite scène obtenues par lecture non destructive d'un capteur d'image, appelées images NDRO, ledit capteur comprenant une pluralité de pixels agencés sous forme matricielle, et associés chacun à un élément de conversion photoélectrique permettant de convertir une lumière reçue en charges électriques et d'accumuler lesdites charges électriques pendant un temps d'exposition à la lumière, **caractérisé en ce que** il comprend une unité de calcul adaptée à la mise en œuvre des étapes du procédé de génération d'image à grande gamme dynamique selon l'une quelconque des revendications 1 à 7.

11. Système (200, 300) de génération d'une image à grande gamme dynamique d'une scène, à partir d'une pluralité d'images de ladite scène obtenues par lecture non destructive d'un capteur d'image, appelées images NDRO, ledit système comprenant un capteur (204, 304) comprenant une pluralité de pixels agencés sous forme matricielle, et associés chacun à un élément de conversion photoélectrique permettant de convertir une lumière reçue en charges électriques et d'accumuler lesdites charges électriques pendant un temps d'exposition à la lumière, ledit capteur étant apte à fonctionner dans un mode de lecture non destructive, **caractérisé en ce qu'**il comprend :

- une unité de calcul (201,301) configurée à comparer, pour chaque pixel d'une image NDRO, parmi une pluralité d'images NDRO successives délivrées par ledit capteur, une valeur de signal correspondant auxdites charges électriques accumulées par ledit pixel à un seuil de sélection de signal, et à sélectionner ledit pixel si ladite valeur de signal associée audit pixel est supérieure audit seuil de sélection de signal et si ledit pixel n'a pas été précédemment sélectionné dans une image NDRO précédente de ladite pluralité d'images NDRO ;
- une mémoire (202, 302) configurée à mémoriser des valeurs de signal associées auxdits pixels sélectionnés desdites images NDRO successives en association avec des temps d'exposition associés auxdites images N DRO ;
- une unité de calcul configurée pour générer ladite image à grande gamme dynamique à partir desdites valeurs de signal associées auxdits pixels sélectionnés pondérées par lesdits temps d'exposition mémorisés en association.

12. Système (200, 300) de génération d'une image à grande gamme dynamique d'une scène selon la revendication 11, **caractérisé en ce que** il comprend également un module d'interface (211, 311) pour saisie par un utilisateur d'un critère de qualité souhaité pour ladite image à grande gamme dynamique et d'un temps d'exposition maximum dudit capteur.

**Patentansprüche**

1. Verfahren zum Erzeugen eines Bildes mit hohem Dynamikbereich einer Szene ausgehend von einer Mehrzahl von Bildern der besagten Szene, welche mittels zerstörungsfreien Auslesens eines Bildsensors erhalten werden, welche NDRO-Bilder genannt werden, wobei der besagte Sensor (204, 304) eine Mehrzahl von Pixeln aufweist, welche in Matrixform angeordnet sind und jeweilig mit einem photoelektrischen Umwandlungselement assoziiert sind, welches es erlaubt, empfangenes Licht in elektrische Ladungen umzuwandeln und die besagten elektrischen Ladungen während einer Zeit der Belichtung mit dem Licht zu akkumulieren, wobei das Verfahren aufweist:

- ein erstes zerstörungsfreies Auslesen des besagten Bildsensors, welches ein aktuelles erstes NDRO-Bild mit dem Index n=0 liefert, und ein Speichern des besagten ersten Bildes innerhalb einer Speicherzone unter Assoziierung mit einer mit dem besagten ersten Bild assoziierten Belichtungszeit, und **gekennzeichnet durch**:
- für jedes Pixel des besagten ersten Bildes, ein Vergleichen eines Signalwertes, welcher zu den besagten mittels des besagten Pixels akkumulierten elektrischen Ladungen korrespondiert, mit einem Signal-Auswahl-Schwellwert, und ein Auswählen des besagten Pixels, falls der besagte mit dem besagten Pixel assoziierte Signalwert größer als der besagte Signal-Auswahl-Schwellwert ist,

- zumindest eine Iteration der folgenden aufeinanderfolgenden Schritte, für ganzzahliges n, wobei n von 1 bis N variiert:

  ∘ ein zerstörungsfreies Auslesen des besagten Bildsensors, welches ein aktuelles NDRO-Bild mit dem Index n liefert,
  ∘ ein Aktualisieren der besagten Speicherzone mittels Speicherns, für jedes Pixel des besagten aktuellen NDRO-Bildes mit dem Index n, welches nicht zuvor in einem dem besagten aktuellen NDRO-Bild vorausgehenden NDRO-Bild ausgewählt wurde, eines mit dem Pixel assoziierten Signalwerts, in Assoziierung mit einer mit dem besagten aktuellen NDRO-Bild mit dem Index n assoziierten Belichtungszeit,
  ∘ für jedes Pixel des besagten aktuellen NDRO-Bildes mit dem Index n, ein Vergleichen eines Signalwertes, welcher zu den besagten elektrischen Ladungen korrespondiert, welche mittels des besagten Pixels akkumuliert werden, mit dem besagten Signal-Auswahl-Schwellwert und ein Auswählen des besagten Pixels, falls der mit dem besagten Pixel assoziierte Signalwert größer ist als der besagte Signal-Auswahl-Schwellwert,

ein Erzeugen (108) des besagten Bildes mit hohem Dynamikbereich ausgehend von den gespeicherten Signalwerten, welche mit den besagten Belichtungszeiten gewichtet sind, welche mit den besagten Signalwerten, welche mit den besagten ausgewählten Pixeln assoziiert sind, und mit den besagten Belichtungszeiten, welche in Assoziierung gespeichert sind, assoziiert sind.

2. Verfahren zum Erzeugen eines Bildes mit hohem Dynamikbereich gemäß Anspruch 1, **dadurch gekennzeichnet, dass** die Schritte des besagten Verfahrens, welche zum besagten Erzeugen des besagten Bildes mit hohem Dynamikbereich notwendig sind, eine einzige Speicherzone implementieren, welche zu einem Bild des Sensors korrespondiert, wobei die Schritte des besagten Verfahrens ein Speichern eines einzigen Bildes zu einem gegebenen Zeitpunkt implementieren.

3. Verfahren zum Erzeugen eines Bildes mit hohem Dynamikbereich gemäß Anspruch 1 oder 2, **dadurch gekennzeichnet, dass** es einen vorbereitenden Schritt des Ermittelns (100) eines gewünschten Qualitätskriteriums für das besagte Bild mit hohem Dynamikbereich und einer maximalen Belichtungszeit des besagten Sensors aufweist.

4. Verfahren zum Erzeugen eines Bildes mit hohem Dynamikbereich gemäß Anspruch 3, **dadurch gekennzeichnet, dass** das besagte gewünschte Qualitätskriterium ein Kriterium des Signal-Rausch-Verhältnisses der Pixel des besagten Bildes mit hohem Dynamikbereich ist.

5. Verfahren zum Erzeugen eines Bildes mit hohem Dynamikbereich gemäß Anspruch 3 oder 4, **dadurch gekennzeichnet, dass** das besagte NDRO-Bild mit dem Index N ist:

   - das erste der besagten aufeinanderfolgenden NDRO-Bilder, in welchem alle Pixel mit einem Signalwert assoziiert sind, welcher größer oder gleich dem besagten Signal-Auswahl-Schwellwert ist,
   oder
   - ein NDRO-Bild, welches mit der besagten maximalen Belichtungszeit des besagten Sensors assoziiert ist, falls es zumindest ein Pixel enthält, welches mit einem Signalwert assoziiert ist, welcher kleiner als der besagte Signal-Auswahl-Schwellwert ist.

6. Verfahren zum Erzeugen eines Bildes mit hohem Dynamikbereich gemäß irgendeinem der Ansprüche 1 bis 5, **dadurch gekennzeichnet, dass** das besagte Erzeugen (108) des besagten Bildes mit hohem Dynamikbereich aufweist ein Berechnen eines Signalwerts, welcher mit jedem Pixel des besagten Bildes mit hohem Dynamikbereich assoziiert ist, mittels ausgewerteter Gewichtung, in Abhängigkeit der Antwort des Sensors, des besagten Signalwerts, welcher in der besagten Speicherzone gespeichert ist, für jedes der besagten Pixel mit der besagten assoziierten Belichtungszeit.

7. Verfahren zum Erzeugen eines Bildes mit hohem Dynamikbereich gemäß irgendeinem der Ansprüche 1 bis 6, **dadurch gekennzeichnet, dass** es gleichermaßen aufweist ein vorheriges Ermitteln einer minimalen Zeit zur Akkumulation elektrischer Ladungen am Bildsensor vor dem besagten ersten zerstörungsfreien Auslesen des besagten Bildsensors, $t_{min}$ genannt,
und dadurch, dass die besagte minimale Zeit zur Akkumulation $t_{min}$ die folgende Bedingung erfüllt:

$$\frac{t_{min}+(t_{NDRO})}{t_{min}} < \frac{S_{sat}}{S_0},$$

wobei:

- $t_{NDR0}$ eine Zeit zwischen zwei besagten aufeinanderfolgenden Iterationen des zerstörungsfreien Auslesens des besagten Bildsensors ist,
- $S_{sat}$ ein Sättigung-Signal des besagten Bildsensors ist,
- $S_0$ ein schwächstes verwertbares elektronisches Signal, ohne Rauschen, ist, welches vom besagten Bildsensor stammt.

8. Computerprogrammprodukt, welches Programmcodeinstruktionen aufweist für das Durchführen eines Verfahrens gemäß irgendeinem der Ansprüche 1 bis 7, wenn es mittels eines Prozessors ausgeführt wird.

9. Von einem Computer lesbares Aufzeichnungsmedium, auf welchem ein Computerprogramm gespeichert ist, welches Programmcodeinstruktionen aufweist für das Ausführen der Schritte des Verfahrens zum Erzeugen eines Bildes mit hohem Dynamikbereich gemäß irgendeinem der Ansprüche 1 bis 7.

10. System zum Erzeugen eines Bildes mit hohem Dynamikbereich einer Szene ausgehend von einer Mehrzahl von Bildern der besagten Szene, welche mittels zerstörungsfreien Auslesens eines Bildsensors erhalten werden, welche NDRO-Bilder genannt werden,
wobei der besagte Sensor eine Mehrzahl von Pixeln aufweist, welche in Matrixform angeordnet sind und jeweilig mit einem photoelektrischen Umwandlungselement assoziiert sind, welches es erlaubt, empfangenes Licht in elektrische Ladungen umzuwandeln und die besagten elektrischen Ladungen während einer Zeit der Belichtung mit dem Licht zu akkumulieren,
**dadurch gekennzeichnet, dass** es eine Recheneinheit aufweist, welche angepasst ist, um Schritte des Verfahrens zum Erzeugen eines Bildes mit hohem Dynamikbereich gemäß irgendeinem der Ansprüche 1 bis 7 durchzuführen.

11. System (200, 300) zum Erzeugen eines Bildes mit hohem Dynamikbereich einer Szene ausgehend von einer Mehrzahl von Bildern der besagten Szene, welche mittels zerstörungsfreien Auslesens eines Bildsensors erhalten werden, welche NDRO-Bilder genannt werden,
wobei das besagte System einen Sensor (204, 304) aufweist, welcher eine Mehrzahl von Pixeln aufweist, welche in Matrixform angeordnet sind und jeweilig mit einem photoelektrischen Umwandlungselement assoziiert sind, welches es erlaubt, empfangenes Licht in elektrische Ladungen umzuwandeln und die besagten elektrischen Ladungen während einer Zeit der Belichtung mit dem Licht zu akkumulieren, wobei der besagte Sensor imstande ist, in einem Zerstörungsfreies-Auslesen-Modus zu arbeiten,
**dadurch gekennzeichnet, dass** es aufweist:

- eine Recheneinheit (201, 301), welche eingerichtet ist, um für jedes Pixel eines NDRO-Bildes von einer Mehrzahl von aufeinanderfolgenden NDRO-Bildern, welche von dem besagten Sensor geliefert werden, einen Signalwert, welcher zu den besagten mittels des besagten Pixels akkumulierten elektrischen Ladungen korrespondiert, mit einem Signal-Auswahl-Schwellwert zu vergleichen, und um das besagte Pixel auszuwählen, falls der besagte mit dem besagten Pixel assoziierte Signalwert größer als der besagte Signal-Auswahl-Schwellwert ist, und falls das besagte Pixel nicht zuvor in einem vorausgehenden NDRO-Bild der besagten Mehrzahl von NDRO-Bildern ausgewählt wurde,
- einen Speicher (202, 302), welcher eingerichtet ist, um Signalwerte, welche mit den besagten ausgewählten Pixeln der besagten aufeinanderfolgenden NDRO-Bilder assoziiert sind, in Assoziierung mit den Belichtungszeiten, welche mit den besagten NDRO-Bildern assoziiert sind, zu speichern,
- eine Recheneinheit, welche eingerichtet ist, um das besagte Bild mit hohem Dynamikbereich ausgehend von den besagten mit den besagten ausgewählten Pixeln assoziierten Signalwerten zu erzeugen, welche mit den besagten Belichtungszeiten, welche in Assoziierung gespeichert sind, gewichtet sind.

12. System (200, 300) zum Erzeugen eines Bildes mit hohem Dynamikbereich einer Szene gemäß Anspruch 11, **dadurch gekennzeichnet, dass** es gleichermaßen ein Schnittstelle-Modul (211, 311) zur Eingabe eines gewünschten Qualitätskriteriums für das besagte Bild mit hohem Dynamikbereich und einer maximalen Belichtungszeit des besagten Sensors durch einen Nutzer aufweist.

**Claims**

1. A method for generating a high dynamic range image of a scene, from a plurality of images of said scene obtained by non-destructive readout of an image sensor, called NDRO images,

   said sensor (204, 304) comprising a plurality of pixels arranged in matrix form, and each associated with a photoelectric conversion element enabling to convert a received light into electric charges and to accumulate the electric charges during an exposure time to the light, the method comprising:

   - a first non-destructive readout of said image sensor, delivering a first current NDRO image with index n=0, and storing of said first image, within a memory zone, in association with an exposure time associated with said first image; and **characterized in that**:
   - for each pixel of said first image, a comparison of a signal value corresponding to said electric charges accumulated by said pixel with a signal selection threshold, and a selection of said pixel if said signal value associated with said pixel is above said signal selection threshold;
   - at least one iteration of the following successive steps, for integer n, n varying from 1 to N:

     - non-destructively reading out said image sensor, delivering a current NDRO image with index n;
     - updating said memory zone by storing, for each pixel of said current NDRO image with index n not previously selected in an NDRO image preceding said current NDRO image, a signal value associated with said pixel, in combination with an exposure time associated with said current NDRO image with index n;
     - for each pixel of said current NDRO image with index n, comparing a signal value corresponding to said electric charges accumulated by said pixel with said signal selection threshold, and selecting said pixel if said signal value associated with said pixel is above said signal selection threshold;

   generating (108) said high dynamic range image from the stored signal values, weighted by said associated exposure times of said signal values associated with said selected pixels and of said exposure times stored in association.

2. The method for generating a high dynamic range image according to claim 1, **characterized in that** the steps of said method necessary to generate said high dynamic range image implement a single memory area corresponding to an image of the sensor, the steps of said method implementing a storage of a single image at a given moment.

3. The method for generating a high dynamic range image according to claim 1 or 2, **characterized in that** it comprises a preliminary step for determining (100) a desired quality criterion for said high dynamic range image and a maximum exposure time for said sensor.

4. The method for generating a high dynamic range image according to claim 3, **characterized in that** said desired quality criterion is a signal-to-noise ratio of the pixels of said high dynamic range image.

5. The method for generating a high dynamic range image according to claim 3 or 4, **characterized in that** said NDRO image with index N is:

   - the first of said successive NDRO images in which all of the pixels are associated with a signal value greater than or equal to said signal selection threshold; or
   - an NDRO image, associated with said maximum exposure time of said sensor, if it contains at least one pixel associated with a signal value below said signal selection threshold.

6. The method for generating a high dynamic range image according to any one of claims 1 to 5, **characterized in that** said generation (108) of said high dynamic range image comprises a calculation of a signal value associated with each pixel of said high dynamic range image by evaluated weight, based on the response from the sensor, of said signal value stored in said memory area for each of said pixels by said associated exposure time.

7. The method for generating a high dynamic range image according to any one of claims 1 to 6, **characterized in that** it also comprises a prior determination of a minimum electric charge accumulation time on the image sensor before the first non-destructive readout of said image sensor, denoted $t_{min}$,

   and **in that** said minimum accumulation time $t_{min}$ satisfies the condition:

$$\frac{t_{min} + (t_{NDRO})}{t_{min}} < \frac{S_{sat}}{S_0}$$

where:

- $t_{NDRO}$ is a time between two of said successive iterations of non-destructive readout of said image sensor;
- $S_{sat}$ is a saturation signal of said image sensor;
- $S_0$ is the weakest usable electronic signal, except noise, coming from said image sensor.

8. A computer program product comprising program code instructions for carrying out a method according to any one of claims 1 to 7, when it is executed by a processor.

9. A recording medium readable by a computer on which a computer program is recorded comprising program code instructions for carrying out steps of the method for generating a high dynamic range image according to any one of claims 1 to 7.

10. A system for generating a high dynamic range image of a scene, from a plurality of images of said scene obtained by non-destructive readout of an image sensor, called NDRO images, said sensor comprising a plurality of pixels arranged in matrix form, and each associated with a photoelectric conversion element enabling to convert a received light into electric charges and to accumulate the electric charges during an exposure time to the light, **characterized in that** it comprises a computing unit suitable for carrying out steps of the method for generating a high dynamic range image according to any one of claims 1 to 7.

11. A system (200, 300) for generating a high dynamic range image of the scene, from a plurality of images of said scene obtained by non-destructive readout of an image sensor, called NDRO images, said system comprising a sensor (204, 304) comprising a plurality of pixels arranged in matrix form, and each associated with a photoelectric conversion element enabling to convert a received light into electric charges and to accumulate the electric charges during an exposure time to the light, said sensor being adapted to operate in a non-destructive readout mode, **characterized in that** it comprises:

- a computing unit (201, 301) configured to compare, for each pixel of an NDRO image, among a plurality of successive NDRO images delivered by said sensor, a signal value corresponding to said electric charges accumulated by said pixel to a signal selection threshold, and to select said pixel if said signal value associated with said pixel is above said signal selection threshold and if said pixel has not been previously selected from a preceding NDRO image from said plurality of NDRO images;
- a memory (202, 302) configured to store signal values associated with said selected pixels of said successive NDRO images in association with exposure times associated with said NDRO images;
- a computing unit configured to generate said high dynamic range image from said signal values associated with said selected pixels weighted by said exposure times stored in association.

12. The system (200, 300) for generating a high dynamic range image of a scene according to claim 11, **characterized in that** it also comprises an interface module (211, 311) for entry by a user of a desired quality criterion for said high dynamic range image and of a maximum exposure time of said sensor.

Fig. 1

_Fig. 2_

EP 3 571 834 B1

Fig. 3

EP 3 571 834 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7868938 B

**Littérature non-brevet citée dans la description**

- **MUSTAPHA BOUDERBANE et al.** Suppression de l'artéfact de ghost pour la génération de vidéo HDR temps-réel. *Compas'2016 : Parallélisme/Architecture/Système,* 05 Août 2016